(19) Europäisches Patentamt
European Patent Office
Office européen des brevets

(11) Publication number : 0 417 942 B1

(12) # EUROPEAN PATENT SPECIFICATION

(45) Date of publication of patent specification : **10.05.95 Bulletin 95/19**

(51) Int. Cl.[6] : **H01L 29/04,** H01L 29/78, H01L 21/205

(21) Application number : **90309501.6**

(22) Date of filing : **30.08.90**

(54) **Manufacture of polycrystalline silicon thin films and of transistors therefrom.**

(30) Priority : **31.08.89 JP 223260/89**

(43) Date of publication of application : **20.03.91 Bulletin 91/12**

(45) Publication of the grant of the patent : **10.05.95 Bulletin 95/19**

(84) Designated Contracting States : **DE FR GB IT NL**

(56) References cited :
**EP-A- 0 043 691**
**EP-A- 0 061 923**
**US-A- 4 800 173**
**PATENT ABSTRACTS OF JAPAN, vol. 13, no. 68 (E-716)[3416], 16th February 1989 ; & JP-A-63 252 419**
**JAPANESE JOURNAL OF APPLIED PHYSICS, vol. 28, no. 5, Part I, May 1989, pp. 829-835, Tokyo, JP ; N. FUJIKI et al.: "Highly oriented polycrystalline Si film on quartz grown from Si3H8 by thermal and photo-CVD"**

(73) Proprietor : **Tonen Corporation**
**1-1 Hitotsubashi, 1-Chome**
**Chiyoda-Ku**
**Tokyo 100 (JP)**

(72) Inventor : **Kakinoki, Hisashi, Tonen Corp.,**
**Corporate Res.**
**and Dev. Lab.,**
**1-3-1, Nishi-Tsurugaoka**
**Ohi-machi, Iruma-gun, Saitama 354 (JP)**
Inventor : **Nagahara, Tatsuro, Tonen Corp.,**
**Corporate Res.**
**and Dev. Lab.,**
**1-3-1, Nishi-Tsurugaoka**
**Ohi-machi, Iruma-gun, Saitama 354 (JP)**
Inventor : **Fukui, Keitaro, Tonen Corp.,**
**Corporate Res.**
**and Dev. Lab.,**
**1-3-1, Nishi-Tsurugaoka**
**Ohi-machi, Iruma-gun, Saitama 354 (JP)**

(74) Representative : **Diamond, Bryan Clive et al**
**Gee & Co.**
**Chancery House**
**Chancery Lane**
**London WC2A 1QU (GB)**

EP 0 417 942 B1

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a polycrystalline silicon thin film to be used in a semiconductor device such as a thin film transistor or solar cell, and to transistors made from these thin films.

A polycrystalline silicon thin film is an aggregation of a large number of silicon crystals of size of several tens of nm (hundreds of Å) to several tens of μm. Compared with amorphous silicon, the mobility of the electrons is higher by one to two orders and it has the excellent property that it can be formed on any substrate (except crystalline silicon), such as alumina or graphite, as has been unachievable with single crystalline silicon. A transistor comprising a polycrystalline silicon thin film has higher mobility than an amorphous silicon transistor and even peripheral driving circuits can be incorporated on the same substrate.

In general, such a polycrystalline silicon thin film is formed by a thermal CVD method on a substrate at a high temperature of 600 - 700°C or more and the substrate must be resistant to high temperature. Also, because the substrate, on which the thin film and transistor are formed, can be lit by back-light if it is transparent, it is suitable for liquid crystal display, and there is a considerable demand to use a transparent substrate, e.g. glass substrate, as the substrate for polycrystalline silicon. However, the strain point of normal glass is 600°C or lower, and it is impossible to form polycrystalline silicon thereon. Therefore, when a polycrystalline silicon thin film is formed on a glass substrate, a heat-resistant glass such as quartz glass must be used. This is not suitable for mass production because it is very expensive.

Also, a polycrystalline silicon thin film has a higher percentage of (220) orientation at low temperature, and the percentage of (220) orientation is decreased at higher temperature, while the percentage of (100) orientation tends to increase with the temperature. Because a conventional type of polycrystalline silicon thin film is formed by the thermal CVD method, process temperature is high. As a result, the percentage of (220) orientation is low, and the percentage of (100) orientation can be increased, whereas the usable substrate is limited because the process temperature is high. In this respect, there has been a great need for a new thin film forming technique, which provides a lower percentage of (220) orientation and a higher percentage of (100) orientation in a low temperature process.

It is said that, when the percentage of (220) orientation is higher, the transistor characteristics, in particular the effective carrier mobility, is increased and the change over time during continuous operation is decreased. Thus, a proposal has been made to increase the percentage of (220) orientation, while this is in imperfect polycrystalline silicon with relatively smaller grain size and it is not certain whether it can be applied to polycrystalline silicon with larger grain size. On the contrary, when the percentage of (220) orientation is high, the percentage of (100) orientation is decreased. This results in the lack of surface flatness and lower yield in microstructure fabrication.

Further, the results of a recent study reveal that, in polycrystalline silicon formed by the thermal CVD method, there are many voids between silicon grains because the temperature during manufacture is high, and that the dangling bonds of grain boundaries impair the electrical properties. To correct such defects, it is necessary to passivate the grain boundary with hydrogen, and this is very disadvantageous.

Because a glass substrate with low strain point is relatively cheap, it is useful for the manufacture of a thin film transistor, whereas a silicon thin film obtained on glass substrate is amorphous because of the restriction in the process temperature. Thus, the technique of forming a polycrystalline silicon thin film with excellent electrical property on a glass substrate with a low strain point is not yet established. When a polycrystalling silicon thin film is formed at relatively low temperature by a conventional technique, the silicon in the interface with the substrate is not crystallized (amorphous silicon) or crystals are found in a finer state (microcrystalline silicon), and it is not possible to obtain polycrystalline silicon of a large grain size.

In this respect, attention is focused now on the plasma CVD method to product a polycrystalline silicon thin film at low temperature (see JP-A-63-157872 and 63-175417). In these methods, a large quantity of hydrogen gas is used as one of the components of the reaction gas, and the polycrystalline silicon thus obtained contains hydrogen between the silicon grains, in contrast to the product obtained by the thermal CVD method. Thus, it is not necessary to passivate polycrystalline silicon with hydrogen after its manufacture. "CVD" refers to chemical vapopr deposition.

However, a polycrystalline silicon thin film obtained by the above method contains hydrogen in an amount of about 2.5 atomic % or more, and the grain size of the silicon is about 500 Å at the most (1 nm = 10 Å).

Also, M. Fujiki et al (Japanese Journal of Applied Physics, Volume 28, Number 5, Part I, May 1989, pages 829-835) describe Si films deposited on quartzs plates grown from $Si_3H_8$ by thermal and photo-CVD which have shown a strong crystalline orientation and are preferentially grown as (110) planes at substrate temperatures below 560°C, but turn to (100) above 575°C. In the transition region, an enhancement of <100> orientation occurs with increasing H2 partial pressure and $Si_3H_8$ flow rate, but <110> - orientation occurs with extremely high $H_2$ pressure and $Si_3H_8$ flowrate. The deposited film are considered to be nearly polycrystalline if not microcrystalline or amorphous.

In addition, JP-A-63252419 describes the formation of a polycrystalline silicon film on an amorphous insulation by vapour growth. A carbon dioxide gas laser beam is applied to its growing surface when the polycrystalline silicon film is made to grow. With a film forming temperature of 650°C, a semiconductor substrate can be obtained on which a polycrystalline silicon film whose face (100) has an orientation rate higher than 0.8 is formed.

Further, EP-A-0043691 describes the deposition of a silicon film on a substrate of hard glass (Cornings 7059 Glass) by performing vacuum evaporation under the conditions of a substrate temperature of 600°C. The crystalline structure in the surface layer of this film has a strong <100> preferred orientation and a <110> preferred orientation coexists weakly.

It is an object of this invention to provide a polycrystalline silicon thin film with large grain size and formed at relatively low temperature, preferably having higher (100) orientation and lower (220) orientation and of high quality.

It is another object of the invention to provide a polycrystalline silicon thin film of high quality formed on a transparent substrate such as of glass.

It is yet another object of the invention to provide a high-performance polycrystalline silicon thin film having a large grain size and with a hydrogen content of 2.5 atomic % or less, or more preferably, 1 atomic % or less, and with a fluorine content of 3 atomic % or less, or more preferably, 1 atomic % or less. It is intended to provide thin film transistors formed of such thin films.

Thus, the present invention provides a polycrystalline silicon thin film formed on a substrate other than of monocrystalline silicon, the <100> preferential orientation of said thin film being 50% or more, said thin film containing a high concentration of dopant near the interface region between said thin film and said substrate, said dopant concentration is at least $10^{18}/cm^3$ or more at 10 nm from said interface and the crystal grain size of the polycrystalline silicon at the upper portion of said thin film is at least 0.2 μm.

When the CVD method is used at low temperature on a glass substrate having a strain point of 600°C or lower, there is then almost no diffusion of impurities from the substrate; the film has preferably,a hydrogen content of 2.5 atomic %, or more preferably, 1 atomic % or less, and fluorine content of 3 atomic %, or more preferably, 1 atomic % or less.

The thin film formed on a transparent substrate can contain near the interface between thin film and substrate, a dopant in a high concentration of at least $10^8/cm^3$ or more at a distance 100 Å from said interface, and the grain size of the polycrystalline silicon in the upper portion of said thin film is then at least 0.2 μm.

The thin film produced by plasma CVD method or photo CVD method on a transparent substrate, e.g. on a glass substrate with a strain point of 600°C or lower, is used to make a transistor device; the source electrode and drain electrode are formed on the silicon thin film, and a gate electrode is formed on the film between the two electrodes through a gate insulating film.

In this invention, a substrate other than single crystalline silicon, such as of glass, ceramic or metal is used. (If a single crystalline silicon were used as substrate, an epitaxial film is obtained if the condition of crystallization is selected as plasma CVD, and a polycrystalline silicon thin film of this invention is not obtained.)

As the film-forming gas to form the polycrystalline silicon, there are silicon hydrides, $SiH_mX_{4-m}$ ($\underline{m}$ is 1 - 4, preferably 2 - 4; X is a Cl or F atom, preferably F), $Si_2H_6$ or $Si_3H_8$, alone, or in a mixture of two or more thereof.

Suitable as the etching gas are $SiF_4$ , $Si_2F_6$, $SiCl_4$ , $F_2$ and $Cl_2$, alone or in a mixture of two or more.

The thin film of this invention can be obtained by keeping a balance between crystal growth and etching, by mixing film-forming gas and etching gas as appropriate. Such balance can be easily adjusted by mixing and using the above film-forming gas and etching gas as appropriate, while it is preferable that $SiF_4$ and $Si_2H_6$ are used alone or admixed. As etching gas, it is preferable to use $SiF_4$ and $F_2$ alone or admixed.

Because the pressure in the chamber to generate the plasma is related to the energy quantity of the atoms, which reach the substrate surface, it is necessary to use a pressure of 2.7 - 2000 Pa (0.02 - 15 Torr), or more preferably, 13 - 666 Pa (0.1 - 5 Torr).

To the above film-forming gas and etching gas, an inert gas such as a rare gas, preferably, helium, neon, argon or hydrogen may be added as a dilutent. The dilutent gas is preferably used in an amount of 1 - 1000 times, or more preferably 5 - 100 times, as much as the etching gas.

For the ratio between film-forming and etching gas, it is preferable to use etching gas in an amount of 1 - 500 times as much as the film-forming gas, or more preferably, 5 - 200 times. If the etching gas is less than the filmforming gas, the substrate surface cannot be maintained in the best condition for the growth of polycrystalline silicon, while if it is more than 500 times as much as the film forming gas, the etching speed becomes too fast, so the speed of growth of silicon crystals is decreased.

The reaction gases satisfying the above conditions are decomposed by glow discharge of a power density of 0.01 - 10 $W/cm^2$, or more preferably, 0.1 - 5 $W/cm^2$, and a polycrystalline silicon thin film is formed on a substrate maintained at constant temperature of about 100 - 700°C, or more preferably, about 300 - 600°C. The discharge mode may be RF (radio frequency), DC (direct current) or MW (microwave).

If the substrate temperature is lower than 100°C, an amorphous phase appears and is converted to a microcrystalline structure, thus impairing product quality. If the substrate temperature is higher than 700°C, the performance characteristics cannot be improved, and the advantage of plasma CVD as low temperature method cannot be utilized.

Power density differs according to the type and pressure of reaction gas. If the power density is lower than 0.01 W/cm$^2$, the pressure of the reaction gas must be decreased, and the film forming speed decreases. If it exceeds 10 W/cm$^2$, it is not desirable because the high density of the thin film cannot be maintained.

As another embodiment of this invention, the thin film can be formed by the plasma CVD method on a substrate of "Corning" 7059 glass (trademark), or a boro-silicated glass having a strain point of 600°C or lower.

As the silicon-atom-supply-gas with film-forming property to form a polycrystalline silicon film on such glass substrate, one or a mixture of $SiF_4$, $Si_2F_6$ and $SiCl_4$ can be used. These gases have been regarded as etching gas in the past in the silicon crystalline thin film manufacturing technique. With a reaction gas containing a small quantity of hydrogen gas, a rôle of silicon-atom-supply-gas with film-forming property has been given to these gases.

It is possible to introduce a hydrogen-atom-supply-gas other than hydrogen gas into the above reaction gases or to introduce $F_2$ or $Cl_2$ (most preferably $F_2$) as etching gas.

A hydrogen-atom-supply-gas other than hydrogen gas is selected from those of the formula $SiH_{4-n}X_n$ ($\underline{n}$ = 0 - 3; X = F or Cl), $Si_2H_6$ and $Si_3H_8$ because these gases do not introduce useless impurities into the reaction system. Particularly, it is desirable to use a silane fluoride, expressed by $SiH_{4-m}X_m$ ($\underline{m}$ = 1 - 3), in order to reduce the danger of ignition.

In the fabrication of the silicon thin film of this embodiment, the balance must be kept between crystal growth and etching. This can be easily adjusted by adequately mixing the silicon-atom-supply-gas with film-forming property and hydrogen gas, or hydrogen-atom-supply-gas other than hydrogen gas if necessary. Particularly, it is preferable to use $SiF_4$ and $Si_2F_6$ as the silicon atom supply gas with film-forming property alone or admixed.

An intrinsic polycrystalline silicon thin film can be formed on a normal glass substrate or substrate other than a single crystalline silicon substrate. Also, it is possible to turn the formed polycrstalline silicon thin film to a p-type or n-type semiconductor by mixing a dopant gas of Group III or V of the Periodic Table into the reaction gas. Examples of dopant gases are a hydride of diborane and arsine.

In the accompanying drawings:

Fig. 1 is a diagram of X-ray diffraction to explain the orientation of polycrystalline silicon in the film of the invention;

Fig. 2 is a schematical section through a polycrystalline silicon transistor of this invention; and

Fig. 3 are sections of other embodiments of a polycrystalline silicon thin film of this invention.

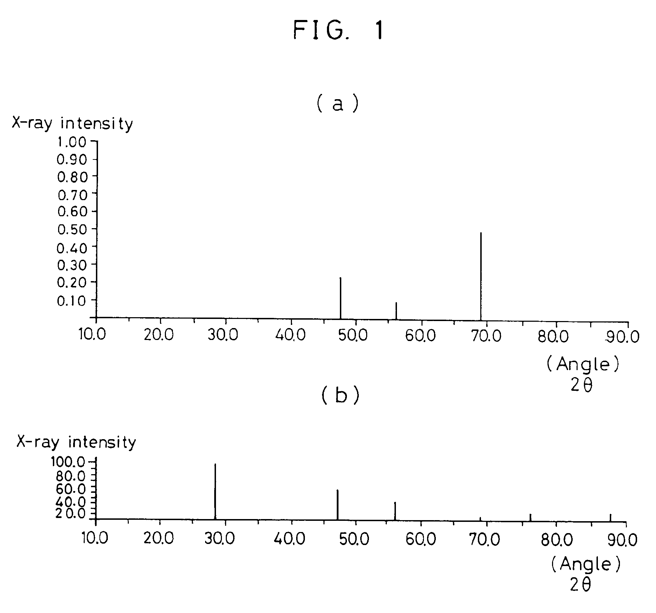

When polycrystalline silicon thin film formed by the predetermined procedure was analyzed by X-ray diffraction, the data as shown in Fig. 1 were obtained.

Fig. 1(a) shows the X-ray diffraction intensity of polycrystalline silicon of this invention, and Fig. 1(b) X-ray diffraction intensity based on a ASTM card 9 standard specimen).

According to the ASTM card, the ratio of diffraction intensity in case of polycrystalline silicon with no preferential orientation is:

(111) : (220) : (311) : (400) = 100 : 55 : 30 : 5

as shown in Fig. 1(b). In contrast, the ratio of X-ray diffraction intensity of thin polycrystalline silicon film as obtained by this invention is:

(111) : (220) ; (311) : (400) = 0 : 23 : 10 : 50

From the ratio of standard value and the measured value, the orientation property is obtained as:

(111) : 0%, (220) : 4%, (311) : 3%, and (400) : 93%.

(400) is identical to (100), and this reveals that the thin polycrystalline silicon film of this invention has very strong (100) orientation. When manufactured under different conditions as shown in the embodiment to be described below, polycrystalline silicon having (100) orientation of 70% or more was obtained.

Because the (100) orientation is 70% or more, the film surface has excellent flatness, and the silicon crystal has also grown to as large as 0.05 - 5 μm, and the surface area of the grains per unit volume is decreased. Thus, the quantity of hydrogen to terminate the dangling bond present at the grain boundary is 1 atomic % or less, and it is easily reduced to 0.2 atomic %. Fluorine also has the function of dangling bond termination, this can contribute to the improvement of electrical property when its quantity contained in the film is 1 atomic % or less.

When a glass substrate is used, it is possible to prevent alkaline impurities such as Na, Ca, K, etc. in the substrate from diffusing toward the polycrystalline silicon because of low processing temperature.

Also, a polycrystalline silicon thin film can be fabricated by the photo CVD method.

In this case, a low pressure mercury lamp having resonance lines at 185 nm and 254 nm is used as light source, and $SiH_4$ and $SiF_4$ are used as film-forming gas and etching gas respectively. The substrate ("Corning" ® 7059 glass) temperature is set to 400°C, and the pressure to about 200 Pa (1.5 Torr). Into a reaction chamber under vacuum condition of 666 x $10^{-6}$ Pa (5 x $10^{-6}$ Torr), $SiH_4$ is introduced by 10 SCCM, $SiF_4$ by 50 SCCM, $H_2$ by 50 SCCM, and Ar as carrier gas for intensifier (Hg) by 50 SCCM (mercury temperature : 80°C), and the low pressure mercury lamp is turned on when the pressure is stabilized. The polycrystalline silicon thin film thus obtained has growth speed 0.3 Å/sec., grain size 1500 Å and (100) orientation 70% or more, as in the case of plasma CVD. When a glass substrate was used, there was almost no diffusion of impurities from the substrate into the polycrystalline silicon.

Thus, the polycrystalline silicon thin film can be fabricated by plasma CVD method and photo CVD method, and a film-forming gas and etching gas are used as raw materials; or a gas can be used having both filmforming property and etching property, such as $SiF_4$ or $Si_2F_6$ , together with hydrogen gas in proportion of 1000/1 - 1/1000, or more preferably, 400/1 - 1/200.

We now describe an embodiment of the film according to the invention, which contains a high concentration of dopant in the interface region between the polycrystalline silicon and the substrate.

In this embodiment, there is no special restriction on the substrate; transparent glass is suitable, and glass with a low strain point (about 600°C or lower) is particularly useful. As the dopant, a known n-type or p-type dopant, e.g. $PH_3$ , $PF_3$, $B_2H_6$, AsCl or $SbCl_3$, may be used; a hydride or fluoride is the most suitable.

According to the invention, dopant is contained at high concentration near the substrate. "Near the substrate" means about 100 - 200 Å from substrate surface, and "high concentration" means $10^{18}$ - $10^{19}$ $cm^3$ or more. The dopant should be present at least at 100 Å from the substrate surface, preferably at 200 Å, with high concentration of $10^{18}/cm^3$ or more, or more preferably, 5 x $10^{19}/cm^3$ or more.

With the dopant at high concentration near the substrate, the crystal grain size of the silicon thin film grows extensively - at least to 0.2 - 0.3 μm, or to 0.5 μm or more, and further to 0.8 - 1 μm or more. Polycrystallines of such large grain size can be formed at 2000 Å from the substrate surface.

There is no special restriction on the thickness of the entire polycrystalline silicon thin film, although it is generally 3000 Å or less in a thin film transistor.

Dopant can be contained in another site than near the substrate. It is desirable to reduce its content more as the distance from the substrate surface becomes greater. A polycrystalline silicon thin film can be fabricated to transistor or other device by doping and other processes.

To form a doped polycrystalline silicon thin film, a solid phase growth method is used, in which amorphous silicon containing dopant at high concentration near substrate surface is heated. In addition to this, thermal CVD method, plasma CVD method, etc. may be used. Thus, a polycrystalline silicon thin film can be formed of a large area, e.g. an area of 300 x 400 mm or more.

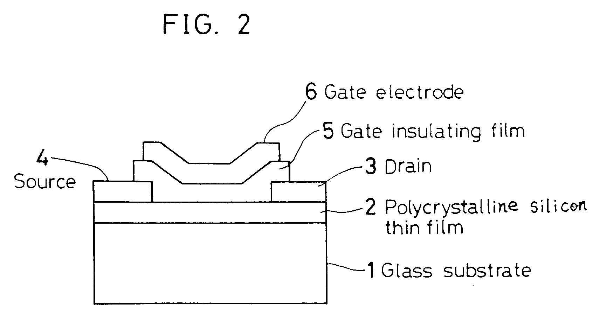

Next, a top-gate coplanar type of polycrystalline silicon thin film transistor is described with reference to Fig. 2.

On the substrate 1 of "Corning" ® 7059 glass, intrinsic polycrystalline silicon thin film 2 is formed on the entire surface by plasma CVD or photo CVD method as described above, and an insulating film 5 such as $SiO_2$ or $SiN_x$ is formed thereon. Next, a photo-resist layer is coated for masking, and the resist pattern is formed by light-exposure and developing. By plasma discharge of an etching gas such as $CF_4$ or $CHF_3$, dry etching is performed, and the insulating film on the region then not covered by the resist is removed. An N-type thin film is formed on the entire surface by mixing dopant gas with the reaction gas as described above, and N-type regions (source and drain regions) are formed. After an N-type thin film is formed, the predetermined resist parameters are formed, and a source electrode 4 and drain electrode 3 are formed by sputtering. Selective formation is performed by lift-off, and N-type thin film on the insulating film 5 is removed by etching. After the insulating film is deposited, a gate electrode 6 is formed, and a thin film transistor is obtained.

A thin film driving circuit such as a liquid crystal display can be obtained by forming an address decoder, memory switch, inverter, etc., using a thin film transistor of this invention.

Under different conditions as described in the example below, a polycrystalline silicon of this invention having (100) orientation of 50% or more, preferably 70% or more, was obtained.

The (220) orientation can be extensively reduced and (100) orientation can be greatly reinforced by plasma CVD, particularly, by using $SiH_4$ and $Si_2H_6$ alone or admixed as film-forming gas on transparent substrate 1, using $SiF_4$ and $F_2$ as etching gas alone or admixed, and using hydrogen gas as dilutent. As described in the subsequent embodiments, a thin film having (220) orientation of 30% or less, preferably 20% or less, can be obtained by changing the manufacturing conditions. When the (220) orientation is 30% or less, (100) orientation increases. The aforesaid preferred (100) and (220) orientation provide excellent flatness of the film surface, and the silicon crystal grains also grow to as large as 0.05 - 5 μm. Because crystal surface area in thin film is decreased, the quantity of hydrogen to terminate the dangling bond present in the grain boundary is 2.5 atomic % or less, and it can be easily reduced to 0.2 - 1 atomic % or less.

Fluorine also has the function of dangling bond termination. By reducing its quantity contained in thin film to 3% or less, e.g. 1 - 3 atomic % or less, it can contribute to the improvement of electrical property. It is particularly preferable that (220) orientation is 20% or less.

The following examples and comparative examples illustrate the invention. Pressures in Torr in the Tables are converted to Pascals by x 133.

Example 1

In a reaction chamber under high vacuum condition of $1.33 \times 10^{-7}$ Pa ($1 \times 10^{-9}$ Torr), a mixed gas consisting of $SiH_4$, $SiF_4$ and $H_2$ in the proportions 1 : 50 : 50 was introduced as reaction gas by 30 SCCM, and the pressure of reaction gas was adjusted to 266 Pa (2.0 Torr). Then, this reaction gas was decomposed by glow discharge with power density of 0.7 W/cm$^2$, using radio frequency power of 13.56 MHz, and silicon thin film was formed on a glass substrate heated at 400°C to the thickness of 2 μm.

When Raman spectroscopy was performed on the film thus obtained, a very sharp spectrum based on crystal silicon was observed with half-width of 5 cm$^{-1}$ at the position of 520 cm$^{-1}$.

When the X-ray intensity was measured by X-ray diffraction to obtain the percentage of (100) orientation, it was 97%. Average grain size was 5500 Å when measured by transmission electron microscopy. The electron mobility of this thin film was obtained by Hall effect, and it was 30 cm$^{-2}$ V$^{-1}$.S$^{-1}$. Hydrogen content was 0.1%, and fluorine content was 0.3%.

Examples 2 - 6

Polycrystalline silicon thin film was obtained under the conditions of Table 1 by the same procedure as in Example 1, and average crystal grain size, hydrogen content and electron mobility were measured. The results were as shown in Table 2.

Table 1

| Example | Type of reaction gas | Ratio | Temperature °C | Pressure (Torr) | Discharge power (W/cm$^2$) |
|---|---|---|---|---|---|
| 2 | $SiH_4:SiF_4:H_2$ | 1:50:70 | 300 | 1.0 | 1.0 |
| 3 | $SiH_4:SiF_4$ | 1:50 | 500 | 2.0 | 1.7 |
| 4 | $Si_2H_6:SiF_4:H_2$ | 1:150:100 | 400 | 1.0 | 1.0 |
| 5 | $SiH_2F_2:SiF_4:H_2$ | 1:100:50 | 600 | 1.0 | 1.0 |
| 6 | $SiH_2CL_2:SiF_4:H_2$ | 1:100:100 | 500 | 0.5 | 1.0 |
| Comparative example | | | | | |
| 2 | $SiH_4:H_2:SiF_4$ | 1:10:10 | 400 | 1.0 | 1.0 |
| 3 | $SiH_4:H_2:SiF_4$ | 1:50:10 | 400 | 1.0 | 1.0 |

Table 2

| Example | Electron mobility ($cm^2/V \cdot S$) | Orientation (%) | Silicon film | Grain size (Å) | Hydrogen (fluorine) content (atom %) |
|---|---|---|---|---|---|
| 2 | 10 | 75 | Polycrystal | 1500 | 0.2 (0.5) |
| 3 | 28 | 93 | Polycrystal | 4500 | 0.1 (0.3) |
| 4 | 23 | 82 | Polycrystal | 4000 | 0.2 (0.5) |
| 5 | 28 | 75 | Polycrystal | 3000 | 0.1 (0.2) |
| 6 | 10 | 70 | Polycrystal | 1000 | 0.2 (0.5) |
| Comparative example | | | | | |
| 2 | 0.3 | 0 | Microcrystal | 150 | 10 (10) |
| 3 | 5 | 30 | Polycrystal. | 300 | 3 ( 3) |

## Comparative Example 1

The specimen was prepared by the same procedure as in Example 1, except that substrate temperature was 300°C, that the pressure in plasma reaction chamber was 666 Pa (5 Torr), that mixed gas containing $SiH_4$ : $H_2$ = 1 : 100 was used as raw material gas, and that plasma CVD was performed with power density of 2 W/cm². In the amorphous silicon of the silicon thin film thus obtained, many microcrystals were present like islands. The hydrogen concentration of this silicon layer was a high as about 8 atomic %. Electron mobility was as low as 0.5 $cm^2$ V-1 S-1, and there was no (100) orientation.

## Comparative Examples 2 and 3

A silicon thin film was formed on a glass substrate by the same procedure as in the Comparative Example 1 under the conditions of Table 1. The silicon thin film thus obtained was as shown in Table 2, and it was confirmed that this was inferior to a polycrystalline silicon thin film of this invention.

## Example 7

In a reaction chamber under high vacuum condition of $1.33 \times 10^{-7}$ Pa ($1 \times 10^{-9}$ Torr), a mixed gas of $H_2$ : $SiF_4$ = 10 : 30 (volume ratio; the amount of F is 60 times as much as H) was supplied as reaction gas by SCCM, and the pressure of reaction gas was adjusted to 66 Pa (0.5 Torr). Next, this reaction gas was turned to plasma by a power flux density of 0.7 W/cm² using a radio frequency power of 13.56 MHz, and a silicon thin film was formed on a substrate of "Corning" 7059 glass heated at 400°C, to a thickness of 1.9 um.

When Raman spectroscopy was performed on the thin film thus obtained, a very sharp spectrum based on crystalline silicon was observed with a half-width of 5 $cm^{-1}$ at 520 $cm^{-1}$.

When the X-ray intensity was measured by X-ray diffraction, the percentage of (100) orientation was 97%. Average grain size was 5000 Å. Further, when measured by Hall effect, the electron mobility of this thin film was 30 $cm^{-2}V^{-1}$ $S^{-1}$.

Hydrogen content was 0.1%, and fluorine content was 0.2%.

## Examples 8 - 13

Polycrystalline silicon thin films were obtained by the same procedure as in Example 7 under the conditions of Table 3. The average crystal grain size, hydrogen content and electron mobility were measured, the results were as summarized in Table 4.

Table 3

| Example | Type of reaction gas | Ratio | Substrate | Temperature °C | Pressure (Torr) | Discharge power ($W/cm^2$) |
|---|---|---|---|---|---|---|
| 8 | $H_2:SiF_4$ | 10:30 | Corning 7059 glass | 300 | 0.5 | 0.5 |
| 9 | $H_2:SiF_4$ | 1:50 | | 500 | 1.5 | 0.8 |
| 10 | $H_2:SiH_4:SiF_4$ | 14:1:100 | | 350 | 1.0 | 1.0 |
| 11 | $H_2:Si_2F_6$ | 50:25 | | 450 | 1.0 | 1.0 |
| 12 | $H_2:SiF_4:F_2$ | 1:30:10 | | 400 | 1.5 | 0.5 |
| 13 | $H_2:SiH_2F_2:SiF_4$ | 1:1:50 | | 350 | 1.2 | 1.3 |

Table 4

| Example | Electron mobility ($cm^2/V \cdot S$) | Orientation (%) | Silicon film | Grain size (μm) | Hydrogen (fluorine) content (atom %) |
|---|---|---|---|---|---|
| 8 | 23 | 88 | Polycrystal | 0.38 | 0.2 (0.5) |
| 8 | 28 | 94 | Polycrystal | 0.47 | 0.1 (0.3) |
| 10 | 25 | 86 | Polycrystal | 0.41 | 0.2 (0.5) |
| 11 | 19 | 83 | Polycrystal | 0.24 | 0.1 (0.3) |
| 12 | 21 | 85 | Polycrystal | 0.27 | 0.1 (0.3) |
| 13 | 10 | 72 | Polycrystal | 0.12 | 0.2 (0.5) |

Comparative Example 4

The specimen was prepared by the same procedure as in Example 1, except that glass substrate temperature was 300°C, that the pressure in plasma reaction chamber was 5 Torr, that mixed gas of $SiH_4 : H_2 = 1 : 100$ was used as raw material gas, and that plasma CVD was performed with power density of 2 $W/cm^2$. In the amorphous silicon phase of the silicon thin film thus obtained, many microcrystals were present like islands. Hydrogen concentration of this silicon layer was as high as about 8 atomic %, and electron mobility was as low as 0.3 $cm^2 V^{-1} .S^{-1}$. There was no (100) orientation.

Comparative Examples 5 and 6

Silicon thin film was formed on a glass substrate by the same procedure as in the Comparative Example 4 under the conditions of Table 5. The thin film thus obtained was as shown in Table 6, and it was confirmed that it was inferior to polycrystalline silicon thin film of this invention.

Comparative Examples 7 - 9

Silicon thin film was formed on a glass substrate by the same procedure as in Example 7 under the condition of Table 7. The results are as shown in Table 8. It was demonstrated from these results that satisfactory results are not obtained when the hydrogen proportion in the reaction gas was too low or when the number of hydrogen atoms were too many compared with the halogen atoms.

Table 5

| Comparative example | Reaction gas | Ratio | Substrate | Temperature °C | Pressure (Torr) | Discharge power ($W/cm^2$) |
|---|---|---|---|---|---|---|
| 5 | $H_2:SiH_4:SiF_4$ | 1:0.1:1 | Corning 7059 glass | 400 | 1.0 | 1.0 |
| 6 | $H_2:SiH_4:SiF_4$ | 1:0.02:0.2 | | 400 | 1.0 | 1.0 |

Table 6

| Comparative example | Electron mobility ($cm^2/V \cdot S$) | Orientation (%) | Silicon film | Average grain size (µm) | Hydrogen (fluorine) content (atom %) |
|---|---|---|---|---|---|
| 5 | 1.1 | 10 % | Microcrystal | 0.015 | 10(10) |
| 6 | 5 | 15 % | Polycrystal | 0.03 | 3 (3) |

Table 7

| Comparative example | Reaction gas | Ratio | Substrate | Temperature °C | Pressure (Torr) | Discharge power ($W/cm^2$) |
|---|---|---|---|---|---|---|
| 7 | $H_2:SiF_4$ | 1:0.8 | Corning 7059 glass | 300 | 1.2 | 0.7 |
| 8 | $H_2:SiF_4$ | 1:0.25 | | 300 | 1.0 | 0.7 |
| 9 | $H_2:SiF_4$ | 1:600 | | 300 | 1.2 | 0.7 |

Table 8

| Comparative example | Electron mobility ($cm^2/V \cdot S$) | Silicon film structure | Average grain size (µm) | Hydrogen (fluorine) content (atom %) |
|---|---|---|---|---|
| 7 | 0.4 | Microcrysal | 0.007 | 7(6) |
| 8 | — | Amorphous | — | 15(4) |
| 9 | — | Film not producible | — | — |

Example 14

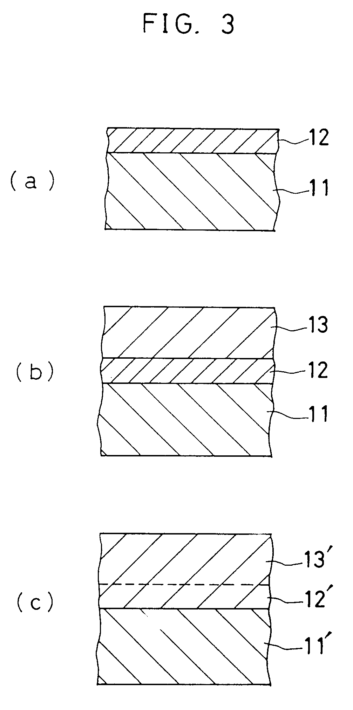

Description is given here in connection with Fig. 3.

Amorphous silicon film 12 containing phosphorus of $5 \times 10^{18}/cm^2$ was formed to the thickness of 100 Å by plasma CVD method on a glass substrate 11 (marketed as HOYA NA-40) with low strain point (about 700°C) (substrate size : 100 x 100 mm) (Fig. 3(a)). Using silane as raw material gas and $PH_3$ as doping gas, a film was formed under the conditions of : $PH_3/SiH_4$ = 20 ppm, flow rate 50 SCCM, substrate temperature 350°C, pressure 200 mTorr, and RF power (13.56 MHz) 0.025 $W/cm^2$.

Then, an amorphous silicon thin film 13 containing phosphorus of $1 \times 10^{17}/cm^3$ was formed on this n-type amorphous silicon thin film 2 to the thickness of 2000 Å. The condition of forming this film was the same as in the case of n-type thin film 12 except that the $PH_3$ concentration was different.

The amorphous silicon thin film thus obtained was annealed at 600°C for 60 hours under a nitrogen atmosphere. As the result, the amorphous silicon 13 was changed to polycrystalline silicon 13′. The average grain size was 0.6 μm, and Hall effect mobility was 50 $cm^2$/V sec.

An n-type thin film 13 was formed to a thickness of 3000 Å by the same procedure as above, except that the n-type thin film 12 was not formed. In the silicon thin film obtained by annealing, the average grain size was 0.4 μm, and the Hall effect mobility was 36 $cm^2$/V sec.

Example 15

In a reaction chamber under high vacuum condition of 1 x $10^{-9}$ Torr, mixed gas consisting of $SiH^4$ : $SiF_4$ : $H_2$ = 1 : 50 : 30 was supplied as reaction gas by 30 SCCM, and the pressure of the reaction gas was adjusted to 266 Pa (2.0 Torr). Then, this reaction gas was decomposed by a glow discharge with a power density of 0.7 W/$cm^2$, using radio frequency power of 13.56 MHz, and a silicon thin film was formed on a "Corning" 7059 glass substrate heated at 400°C to a thickness of 1 μm.

Raman spectroscopy performed on this film gave a very sharp spectrum based on crystalline silicon was observed with half-width of 5 $cm^{-1}$ at 520 $cm^{-1}$.

When X-ray intensity was measured by X-ray diffraction, the percentage of (100) orientation was 97%. By transmission electron microscope, the average grain size was measured as 4500 Å. Further, electron mobility was measured by the Hall effect as 40 $cm^{-2}$ $V^{-1}$ $S^{-1}$ . The hydrogen content was 0.1%, and fluorine content was 0.2%.

Using this polycrystalline silicon thin film, a top-gate coplanar type of TFT was fabricated by the above procedure, and the field effect mobility was measured as 38 $cm^2$/V sec., and it was confirmed that its property was adequate.

Examples 16 - 20

A polycrystalline silicon thin film was obtained by the same procedure as in Example 15 under the conditions shown in Table 9, and the average crystal grain size, hydrogen content and electron mobility were measured. The results are summarized in Table 10.

Comparative Example 10

The specimen was prepared by the same procedure as in Example 1, except that the substrate temperature was 300°C, the pressure in the plasma reaction chamber was 665 Pa (5 Torr), a mixed gas consisting of $SiH_4$ : $H_2$ = 1 : 100 was used as raw material gas, and that plasma CVD was performed with power density of 2 W/$cm^2$. In the amorphous silicon phase of the silicon thin film thus obtained, many microcrystals were present like islands. Hydrogen concentration of this silicon layer was as high as 8 atom %, and electron mobility was as low as 0.3 $cm^2$ $V^{-1}$ $S^{-1}$. There was no (100) orientation, and this thin film was not suitable for TFT.

Table 9

| Example | Type of reaction gas | Ratio | Temperature °C | Pressure (Torr) | Discharge power ($W/cm^2$) |
|---|---|---|---|---|---|
| 16 | $SiH_4:SiF_4:H_2$ | 1:50:30 | 300 | 0.5 | 1.1 |
| 17 | $SiH_4:SiF_4:H_2$ | 1:50:20 | 500 | 0.5 | 1.7 |
| 18 | $H_2:SiF_4$ | 20:50 | 400 | 1.0 | 1.0 |
| 19 | $SiH_2F_2:SiF_4$ | 1:100 | 550 | 1.0 | 1.0 |
| 20 | $SiH_2CL_2:SiF_4$ | 1:100 | 500 | 1.5 | 1.0 |
| Comparative example | | | | | |
| 11 | $SiH_4:H_2:SiF_4$ | 1:10:10 | 400 | 1.0 | 1.0 |
| 12 | $SiH_4:H_2:SiF_4$ | 1:50:10 | 400 | 1.0 | 1.0 |

Table 10

| Example | Electron mobility ($cm^2/V \cdot S$) | Orientation (%) | Silicon film | Grain size Å | Hydrogen (fluorine) content (atom %) | Field effect mobility ($cm^2.V \cdot S$) |
|---|---|---|---|---|---|---|
| 16 | 10 | 75 | Polycrystal | 1500 | 0.2 (0.5) | 8 |
| 17 | 28 | 93 | Polycrystal | 4500 | 0.1 (0.3) | 23 |
| 18 | 23 | 82 | Polycrystal | 4000 | 0.2 (0.5) | 25 |
| 19 | 28 | 75 | Polycrystal | 3000 | 0.1 (0.2) | 28 |
| 20 | 10 | 70 | Polycrystal | 1000 | 0.2 (0.5) | 7 |
| Comparative example | | | | | | |
| 11 | 0.3 | 0 | Microcrystal | 150 | 10 (10) | 0.4 |
| 12 | 5 | 30 | Polycrystal | 300 | 3 ( 3) | 3 |

Comparative Examples 11 and 12

Silicon thin film was formed on a glass substrate by the same procedure as in Comparative Example 10 under the conditions of Table 9. The silicon thin film thus obtained was as shown in Table 10. It was confirmed that this was inferior to polycrystalline silicon thin film of this invention and was not suitable for TFT.

Examples 21 - 25

Polycrystalline silicon thin film was obtained by the same procedure as in Example 15 under the conditions of Table 11, and average crystal grain size, hydrogen content and electron mobility were measured. The results were as shown in Table 12.

Comparative Examples 13 and 14

Silicon thin film was formed on a glass substrate by the same procedure as in Comparative Example 10 under the conditions of Table 11. Silicon thin film thus obtained was as shown in Table 12. It was confirmed that it was inferior to polycrystalline silicon thin film of this invention and was not suitable for TFT.

Table 11

| Example | Type of reaction gas | Ratio | Temperature °C | Pressure (Torr) | Discharge power ($W/cm^2$) |
|---|---|---|---|---|---|
| 21 | $SiH_4:SiF_4:H_2$ | 1:50:30 | 300 | 0.5 | 1.1 |
| 22 | $SiH_4:SiF_4:H_2$ | 1:50:20 | 500 | 0.5 | 1.7 |
| 23 | $H_2:SiF_4$ | 20:50 | 400 | 1.0 | 1.0 |
| 24 | $SiH_2F_2:SiF_4$ | 1:100 | 550 | 1.0 | 1.0 |
| 25 | $SiH_2CL_2:SiF_4$ | 1:100 | 500 | 1.5 | 0.8 |
| Comparative example | | | | | |
| 13 | $SiH_4:H_2:SiF_4$ | 1:10:10 | 400 | 1.0 | 1.0 |
| 14 | $SiH_4:H_2:SiF_4$ | 1:50:10 | 400 | 1.0 | 1.0 |

Table 12

| Example | Electron mobility ($cm^2/V\cdot S$) | Orientation (%) | Silicon film | Grain size Å | Hydrogen (fluorine) content (atom %) | Field effect mobility ($cm^2/V\cdot S$) |
|---|---|---|---|---|---|---|
| 21 | 12 | 70 | Poly-crystal | 1500 | 0.2 (0.5) | 10 |
| 22 | 28 | 93 | Poly-crystal | 4500 | 0.1 (0.3) | 23 |
| 23 | 23 | 82 | Poly-crystal | 4000 | 0.2 (0.5) | 25 |
| 24 | 28 | 75 | Poly-crystal | 3000 | 0.1 (0.2) | 28 |
| 25 | 6 | 50 | Poly-crystal | 1000 | 0.2 (0.5) | 5 |
| Comparative example | | | | | | |
| 13 | 0.3 | 0 | Micro-crystal | 150 | 10 (10) | 0.4 |
| 14 | 5 | 30 | Poly-crystal | 300 | 3 ( 3) | 3 |

Example 26

Silicon thin film was formed on a glass substrate by the same procedure as in Example 15 to a thickness of 1 μm.

When Raman spectroscopy was performed on the film thus obtained, a very sharp spectrum based on crystal silicon was observed with a half-width of 5 $cm^{-1}$ at 520 $cm^{-1}$.

When X-ray intensity was measured by X-ray diffraction to obtain the percentage of orientation , of (220) was 2% or less, and (100) was 97%. By transmission electron microscope, the average grain size was measured as 4500 Å. Further, electron mobility of this thin film was measured by the Hall effect as 40 $cm^{-2}$ $V^{-1}$ $S^{-1}$. The hydrogen content was 0.1%, and fluorine content was 0.2%.

Using this polycrystalline silicon thin film, a top-gate coplanar TFT was fabricated by the above procedure, and its field effect mobility was obtained as 38 $cm^2/V$ sec., and it was confirmed that the product had suitable property.

Thus, a transistor with satisfactory characteristics was obtained even when a glass substrate with low strain point was used. Naturally, better characteristics can be obtained if glass with higher strain point is used.

Examples 27 - 31

Polycrystalline silicon thin film was obtained by the same procedure as in Example 15 under the conditions of Table 11, and average crystal grain size, hydrogen content and electron mobility were measured. The results are summarized in Table 13.

Table 13

| Example | Electron mobility ($cm^2/V \cdot S$) | Orientation (220) (%) | Silicon film | Grain size Å | Hydrogen (fluorine) content (atom %) | Field effect mobility ($cm^2/V \cdot S$) |
|---|---|---|---|---|---|---|
| 27 | 12 | 19 | Poly-crystal | 1500 | 0.2 (0.5) | 10 |
| 28 | 28 | 5 | Poly-crystal | 4500 | 0.1 (0.3) | 23 |
| 29 | 23 | 13 | Poly-crystal | 4000 | 0.2 (0.5) | 25 |
| 30 | 28 | 18 | Poly-crystal | 3000 | 0.1 (0.2) | 28 |
| 31 | 6 | 27 | Poly-crystal | 1000 | 0.2 (0.5) | 5 |
| Comparative example | | | | | | |
| 16 | 0.3 | 82 | Micro-crystal | 150 | 10 (10) | 0.4 |
| 17 | 5 | 67 | Poly-crystal | 300 | 3 (3) | 3 |

Comparative Example 15

The specimen was prepared by the same procedure as in Example 1, except that the substrate temperature was 300°C, the pressure in the plasma reaction chamber was 666 Pa (5 Torr), mixed gas consisting of $SiH_4 : H_2 = 1 : 100$ was used as raw material gas, and plasma CVD was performed at a power density of 2 $W/cm^2$. In the amorphous silicon phase of silicon thin film thus obtained, many microcrystals were present as islands. The hydrogen concentration of this silicon layer was as high as about 8 atomic %, and the electron mobility was as low as 0.3 $cm^2 V^{-1} S^{-1}$. The proportion of (220) was 55%, and of (100) was 8. This thin film was not suitable for TFT.

Comparative Examples 16 and 17

Silicon thin film was formed on a glass substrate by the same procedure as in Comparative Example 15 under the conditions of Table 11. The silicon thin film thus obtained was as shown in Table 13. It was confirmed that it was inferior to polycrystalline silicon thin film of this invention and was not suitable for TFT.

## Claims

1. A polycrystalline silicon thin film formed on a substrate other than of monocrystalline silicon, the <100> preferential orientation of said thin film being 50% or more, said thin film containing a high concentration of dopant near the interface region between said thin film and said substrate, said dopant concentration is at least $10^{18}/cm^3$ or more at 10 nm from said interface and the crystal grain size of the polycrystalline silicon at the upper portion of said thin film is at least 0.2 μm.

2. A silicon thin film according to Claim 1, wherein said substrate is a glass substrate having a strain point of 600°C or lower.

3. A silicon thin film according to Claim 1 or 2, wherein the hydrogen content is 1 atomic % or less, the fluorine content is 1 atomic % or less, and the average crystal grain size is 0.05 - 5 μm.

4. A silicon thin film according to Claim 1 or 2, wherein the hydrogen content is 2.5 atomic % less, and the fluorine content is 3 atomic % or less.

5. A silicon thin film according to any preceding claim, wherein the substrate is transparent.

6. A silicon thin film according to any preceding claim, wherein the (220) orientation in the film is less than 30%.

7. A transistor device, wherein a source electrode and drain electrode are provided on a polycrystalline silicon thin film according to any preceding claim, and a gate electrode is provided on the thin film between the two electrodes through an insulating film.

**Patentansprüche**

1. Polykristalliner dünner Silicium-Film, der auf einem Substrat gebildet ist, das kein Einkristall-Silicium ist, wobei die <100>-Vorzugsorientierung des dünnen Films 50 % oder mehr ist und der dünne Film eine hohe Konzentration an Dotiermittel in der Nähe des Grenzflächen-Bereichs zwischen dem dünnen Film und dem Substrat enthält, wobei die Dotiermittel-Konzentration wenigstens $10^{18}/cm^3$ oder mehr in einer Entfernung von 10 mm von der Grenzfläche beträgt und die Kristallkorn-Größe des polykristallinen Siliciums im oberen Bereich des dünnen Films wenigstens 0,2 μm beträgt.

2. Dünner Silicium-Film nach Anspruch 1, worin das Substrat ein Glassubstrat ist, das einen Wert der unteren Entspannungstemperatur (strain point) von 600 °C oder niedriger aufweist.

3. Dünner Silicium-Film nach Anspruch 1 oder 2, worin der Wasserstoffgehalt 1 Atom-% oder weniger beträgt, der Fluor-Gehalt 1 Atom-% oder weniger beträgt und die mittlere Kristallkorn-Größe 0,05 bis 5 μm beträgt.

4. Dünner Silicium-Film nach Anspruch 1 oder 2, worin der Wasserstoffgehalt 2,5 Atom-% oder weniger beträgt und der Fluorgehalt 3 Atom-% oder weniger beträgt.

5. Dünner Silicium-Film nach einem der vorangehenden Ansprüche, worin das Substrat transparent ist.

6. Dünner Silicium-Film nach einem der vorangehenden Ansprüche, worin die (220)- Orientierung in dem Film weniger ist als 30 %.

7. Transistor-Vorrichtung, in der eine Source-Elektrode und eine Drain-Elektrode auf einem polykristallinen dünnen Silicium-Film gemäß einem der vorangehenden Ansprüche geschaffen sind und eine Gate-Elektrode auf einem isolierenden Film zwischen den beiden Elektroden auf dem dünnen Film geschaffen ist.

**Revendications**

1. Une couche mince en silicium polycristallin formée sur un substrat autre qu'en silicium monocristallin, l'orientation <100> privilégiée de cette couche mince étant d'au moins 50 %, cette couche mince contenant une forte concentration de dopant près de la zone d'interface entre la couche mince et le substrat, la concentration du dopant étant d'au moins $10^{18}/cm^3$ à 10 nm de l'interface et la grosseur de grain des cristaux du silicium polycristallin dans la portion supérieure de la couche mince étant d'au moins 0,2 μ.

2. Une couche mince en silicium selon la Revendication 1, dans laquelle le substrat est un substrat en verre ayant un point de déformation de 600°C ou inférieur.

3. Une couche mince en silicium selon la Revendication 1 ou 2, dans laquelle la teneur en hydrogène est d'1 % atomique ou moins, la teneur en fluor est d'1 % atomique ou moins, et la grosseur de grain moyenne des cristaux est de 0,05 à 5 μ.

4. Une couche mince en silicium selon la Revendication 1 ou 2, dans laquelle la teneur en hydrogène est de 2,5 % atomiques ou moins, et la teneur en fluor est de 3 % atomiques ou moins.

5. Une couche mince en silicium selon l'une ou l'autre des revendications qui précèdent, dans laquelle le substrat est transparent.

6. Une couche mince en silicium selon l'une ou l'autre des revendications qui précèdent, dans laquelle l'orientation <220> dans la couche est inférieure à 30 %.

7. Un dispositif à transistor, dans lequel une électrode de source et une électrode drain sont placées sur une couche mince en silicium polycristallin selon l'une ou l'autre des revendications qui précèdent, et une électrode de grille est placée sur la couche mince entre les deux électrodes via une couche isolante.

FIG. 1

(a)

X-ray intensity
1.00
0.90
0.80
0.70
0.60
0.50
0.40
0.30
0.20
0.10
10.0
20.0
30.0
40.0
50.0
60.0
70.0
80.0
90.0
(Angle)
2θ

(b)

X-ray intensity
100.0
80.0
60.0
40.0
20.0
10.0
20.0
30.0
40.0
50.0
60.0
70.0
80.0
90.0
(Angle)
2θ

FIG. 2

6 Gate electrode
5 Gate insulating film
4
Source
3 Drain
2 Polycrystalline silicon
thin film
1 Glass substrate

FIG. 3

(a)
12
11

(b)
13
12
11

(c)
13′
12′
11′